# FASCICULE DE BREVET EUROPEEN

(11) **EP 1 433 206 B1**
(45) Date de publication et mention de la délivrance du brevet: **06.07.2011**
(21) Numéro de dépôt: 02800173.3
(22) Date de dépôt: 02.10.2002
(51) Int. Cl.: H01L 29/76, H01L 21/336, H01L 29/08

(54) **TRANSISTOR A UN ELECTRON ET A CANAL VERTICAL, ET PROCEDES DE REALISATION D'UN TEL TRANSISTOR**
EIN-ELEKTRON-TRANSISTOR MIT EINEM VERTIKALKANAL, UND HERSTELLUNGSVERFAHREN DAFÜR
SINGLE ELECTRON TRANSISTOR WITH VERTICAL CHANNEL, AND PRODUCTION METHODS THEREOF

(30) Priorité: 04.10.2001 FR 0112755
(43) Date de publication de la demande: 30.06.2004
(73) Titulaire: Commissariat à l'Énergie Atomique et aux Énergies Alternatives, 75015 Paris (FR)
(72) Inventeur: FRABOULET, David, F-38950 Quaix en Chartreuse (FR); DELEONIBUS, Simon 40, allée des Giteaux, F-38640 Claix (FR)
(74) Mandataire: Poulin, Gérard
(86) Numéro de dépôt international: PCT/FR2002/003354
(87) Numéro de publication internationale: WO 2003/030266

(56) Documents cités:
- WO-A-01/06542
- US-A- 5 545 586
- US-A- 5 899 734
- US-B1- 6 221 720
- HUANG S ET AL: "CONTROL OF INTERDOT SPACE AND DOT SIZE IN A TWO-DIMENSIONAL GOLD NANODOT ARRAY" JAPANESE JOURNAL OF APPLIED PHYSICS, PUBLICATION OFFICE JAPANESE JOURNAL OF APPLIED PHYSICS. TOKYO, JP, vol. 38, no. 4B, PART 2, 15 avril 1999 (1999-04-15), pages L473-L476, XP000912797 ISSN: 0021-4922
- AUSTING D G ET AL: "MULTIPLE-GATED SUBMICRON VERTICAL TUNNELLING STRUCTURES" SEMICONDUCTOR SCIENCE AND TECHNOLOGY, INSTITUTE OF PHYSICS. LONDON, GB, vol. 12, no. 5, 1 mai 1997 (1997-05-01), pages 631-636, XP000688279 ISSN: 0268-1242

## Description

### Domaine technique

La présente invention concerne des procédés de réalisation de transistors SET (Single Electron Transistor) dit « à un électron ».

Les transistors à un électron sont encore appelés transistors à blocage de Coulomb. Ils présentent un canal extrêmement mince, qui s'apparente à une boîte quantique, et qui est connecté à une source et à un drain par l'intermédiaire de jonctions tunnel. La conduction du canal est modifiée de façon importante selon qu'une charge faible, de l'ordre de la charge de l'électron, est ou non « stockée » dans la boîte quantique.

L'invention trouve des applications de façon générale dans les domaines de l'électronique, et notamment pour la fabrication de circuits intégrés incluant des structures de transistors de commutation ou de mémoire.

### Etat de la technique antérieure

L'état de la technique de l'invention, est illustré par les documents (1) , (2) et (3) dont les références sont précisées à la fin de la présente description.

La fabrication des transistors à un électron présente un certain nombre de difficultés. Parmi celles-ci, on peut relever la difficulté de réalisation d'un canal suffisamment fin. Une autre difficulté est liée à l'association au canal des source, drain et grille.

En effet, entre la source et le drain d'une part, et le canal d'autre part, une capacité électrique doit être la plus faible possible. Ceci est nécessaire pour autoriser des fréquences de fonctionnement élevées du transistor. En revanche, la capacité entre le canal et la grille doit être importante pour une bonne commande du transistor.

Le document WO 01/06542 montre un transistor vertical.

### Exposé de l'invention

La présente invention a pour but de proposer des procédés de fabrication d'un transistor à blocage de Coulomb tels que définis dans les revendications 1 et 5, permettant de surmonter les difficultés mentionnées ci-dessus.

Un but de l'invention est en particulier de proposer un procédé de fabrication d'un transistor avec de faibles capacités de jonction drain-canal et source-canal tout en garantissant une forte capacité grille-canal.

Un but est encore de proposer des procédés de fabrication fiables et reproductibles du transistor.

Un autre but de l'invention est de proposer des procédés adaptés à la fabrication collective d'un grand nombre de transistors, éventuellement connectés dans des circuits de commutation ou de mémoire.

Selon une caractéristique du transistor, l'empilement de couches de canal comporte un ou plusieurs îlots nanométriques de matériau conducteur, disposé(s) entre des couches électriquement isolantes.

Grâce à l'empilement des couches du canal, c'est-à-dire à la disposition du canal perpendiculairement au substrat, et grâce à la disposition de la ou des grilles sur les flancs du canal, le transistor présente une forte capacité grille-canal. Par ailleurs, grâce à l'empilement des source et drain avec les couches du canal, les capacités source-canal ou drain-canal peuvent être rendues très faibles.

Le terme "conducteur", utilisé pour qualifier le matériau des îlots est considéré comme tel par opposition aux matériaux diélectriques. Il peut donc s'agir soit d'un matériau conducteur tel qu'un métal ou d'un matériau semi-conducteur susceptible de former la boîte quantique. Le matériau conducteur peut se présenter sous la forme d'une couche continue ou sous forme de particules granulaires enrobées dans un matériau isolant. A titre d'exemple, les îlots peuvent être formés par des nanocristaux de semi-conducteur (silicium) ou encore des grains métalliques (aluminium).

L'effet de blocage de Coulomb peut être accentué en mettant en série plusieurs boîtes quantiques, c'est-à-dire en répétant les alternances matériau conducteur/matériau isolant dans l'empilement du canal.

Un premier procédé de fabrication d'un transistor tel qu'indiqué ci-dessus comporte, conformément à l'invention, les étapes successives suivantes :
- le dépôt sur un substrat isolant d'une couche de source, d'une couche d'isolant tunnel et un empilement alterné d'au moins une couche conductrice et d'au moins d'une couche isolante,
- une première gravure ultime de l'empilement pour former une languette filiforme,
- l'enrobage de la languette filiforme avec un matériau d'enrobage isolant électrique,
- une deuxième gravure ultime de la languette de l'empilement pour former une colonnette, la deuxième gravure préservant le matériau d'enrobage pour définir des gorges de part et d'autre de la colonnette,
- la formation d'au moins une grille isolée dans les gorges,
- la formation d'un drain en contact avec une extrémité de la colonnette opposée à la couche de source, par l'intermédiaire d'au moins une couche d'isolant tunnel.

Dans les transistors à effet de champ, les régions de source et de drain sont généralement interchangeables. Ceci est également vrai pour le transistor fabriqué selon l'invention. Ainsi, la couche de source mentionnée dans le procédé peut servir de drain et le drain formé sur l'empilement peut servir de source.

Par ailleurs, on désigne par "gravure ultime" une gravure aux limites de la résolution des techniques de lithographie. La forme d'une languette filiforme est celle qui se prête le mieux à la gravure ultime. Il est, par exemple, possible de graver dans l'empilement des languettes dont la largeur parallèlement au substrat est inférieure ou égale à 5 nm.

La colonnette résulte de la combinaison des deux gravures. Les deux gravures utilisent de préférence des masques filiformes et la colonnette correspond à un emplacement qui est successivement recouvert par chacun des masques. Les dimensions les plus réduites pour la section de la colonnette sont obtenues lorsque les directions des masques filiformes sont perpendiculaires entre elles dans des plans parallèles à la surface du substrat.

Le matériau d'enrobage a un triple rôle d'isolation électrique, de maintien mécanique de la colonnette très fine, et enfin, de formation d'un moule, en l'occurrence des gorges, pour la fabrication ultérieure d'une ou de plusieurs grilles.

Le procédé tel qu'indiqué ci-dessus peut être complété par des étapes, connues en soi, de formation de bornes de connexion pour la prise de contact sur la grille, sur la couche de source et sur le drain.

La ou les grilles formées de part et d'autre de la colonnette sont des grilles isolées. Elles sont en effet isolées électriquement de l'empilement, mais aussi des source et drain tout proches. La formation de la grille peut comporter, par exemple, le dépôt dans les gorges d'un matériau d'isolant de grille, d'une couche de contact et d'un matériau de grille, puis le planage de ces couches avec arrêt sur la colonnette.

De façon avantageuse, le planage peut avoir lieu avec arrêt sur une portion d'une couche de gabarit utilisée comme masque de gravure lors de la première gravure, et préservée au sommet de la colonnette. Le même matériau peut aussi être préservé dans une région extérieure à celle de la fabrication du transistor, pour faciliter l'arrêt de planage.

Conformément à une variante de l'invention, un second procédé de fabrication d'un transistor tel qu'indiqué ci-dessus comporte les étapes successives suivantes :
- le dépôt sur un substrat isolant d'une couche de source, d'une couche d'isolant tunnel et un empilement alterné d'au moins une couche conductrice et d'au moins d'une couche isolante,
- une première gravure de l'empilement selon une couche de gabarit pour former une bande,
- l'enrobage de la bande avec un matériau d'enrobage isolant électrique,
- une deuxième gravure de la bande de l'empilement pour former une colonne, la deuxième gravure préservant le matériau d'enrobage pour définir des gorges de part et d'autre de la colonne, et la deuxième gravure préservant une partie de la couche de gabarit sur la colonne,
- la formation d'au moins une grille isolée dans les gorges,
- le retrait de la couche de gabarit pour dégager une partie de la grille isolée et la formation contre la grille isolée d'au moins un espaceur s'étendant partiellement sur la colonne,
- la gravure de la colonne, en utilisant l'espaceur comme masque de gravure, de façon à préserver au moins une partie de la colonne disposée sous l'espaceur,
- le découpage de colonnettes dans la partie préservée de la colonne,
- l'enrobage isolant des colonnettes, et
- la formation d'au moins un drain en contact avec au moins une extrémité d'une colonnette, opposée à la couche de source, par l'intermédiaire d'au moins une couche d'isolant tunnel.

Les termes "bande" et "colonne" sont utilisés par contraste avec "languette" et "colonnette" pour signifier qu'il ne s'agit pas nécessairement là du résultat de gravures ultimes. Effectivement, les dimensions des colonnettes finalement obtenues, toujours très petites, ne sont pas dictées par la largeur de la bande ou par les dimensions de la colonne. Au moins une dimension des colonnettes- est fixée par la largeur des espaceurs latéraux formés successivement sur la ou les grilles. Les espaceurs latéraux peuvent être obtenus d'une façon bien connue en soi, par dépôt conforme d'une couche de matériau puis par gravure anisotrope de cette couche pour en éliminer toutes les parties parallèles à la surface du substrat. La largeur des espaceurs, et donc une dimension des colonnettes, dépendent de la largeur des espaceurs, c'est-à-dire notamment de la durée de la gravure et de l'épaisseur de la couche de matériau déposée.

Il convient de préciser que le procédé peut être mis en oeuvre en formant plusieurs colonnettes, plusieurs grilles et plusieurs drains. Différentes possibilités pour le découpage des colonnettes sont également proposées.

Selon une première possibilité, le découpage des colonnettes dans la partie préservée de la colonne peut comporter :
- la formation au-dessus de la partie préservée de la colonne, d'un pavé sacrificiel de matériau de masque, avec au moins un flanc définissant un bord d'au moins une colonnette devant être formée,
- la formation d'au moins un espaceur sur le flanc du pavé sacrificiel
- la gravure de la partie préservée de la colonne, en utilisant l'espaceur du pavé sacrificiel comme masque de gravure, pour préserver la colonnette sous cet espaceur.

L'espaceur peut définir un second bord de la colonnette ou s'étendre jusqu'au-dessus du matériau d'enrobage.

Le pavé sacrificiel peut être utilisé seulement pour la fabrication des espaceurs. Dans ce cas, il est de préférence éliminé avant la gravure des colonnettes. Toutefois, jusqu'à leur enrobage, les colonnettes se dressent sans soutien mécanique latéral et sont donc assez fragiles.

Pour cette raison, il est possible, selon un perfectionnement, de prévoir un découpage des colonnettes en deux temps, avec une consolidation intermédiaire. Dans ce cas la gravure comporte :
- une première gravure en utilisant le pavé sacrificiel et l'espaceur du pavé comme masque de gravure,
- la consolidation de la partie restante de la colonne par un matériau isolant électrique,
- l'élimination du pavé sacrificiel, en préservant l'espaceur du pavé sacrificiel, et
- une deuxième gravure en utilisant l'espaceur du pavé sacrificiel comme masque, pour définir au moins une colonnette.

Le procédé se poursuit comme indiqué précédemment par l'enrobage et l'isolation des colonnettes. Ces opérations peuvent avoir lieu en recouvrant les faces latérales libres des colonnettes avec un matériau isolant qui joue alors le rôle de soutien mécanique et d'isolant électrique. Il s'agit, par exemple, du même matériau que celui utilisé pour la consolidation intermédiaire.

D'autres caractéristiques et avantages de l'invention ressortiront de la description qui va suivre, en référence aux figures des dessins annexés. Cette description est donnée à titre purement illustratif et non limitatif.

### Brève description des figures.

La figure 1 est une coupe schématique d'un substrat utilisé pour la fabrication d'un transistor fabriqué selon l'invention.
La figure 2 est une vue de dessus du substrat de la figure 1.
La figure 3 est une coupe schématique (III-III) à plus grande échelle d'une partie centrale du dispositif de la figure 2 sur lequel on a formé un empilement de couches.
La figure 4 est une vue de dessus élargie du dispositif de la figure 3 après une première gravure.
La figure 5 est une vue de dessus du dispositif de la figure 4 et illustre la formation d'un second masque de gravure.
La figure 6 est une vue de dessus du dispositif de la figure 5 après une seconde gravure.
La figure 7 est une coupe schématique du dispositif de la figure 6 et illustre une étape intermédiaire de fabrication d'une grille isolée.
La figure 8 est une coupe schématique du dispositif de la figure 6 et illustre l'achèvement de la grille isolée.
La figure 9 est une vue de dessus élargie du dispositif de la figure 8 et illustre la formation d'un accès de drain.
Les figures 10 et 11 sont des coupes schématiques à plus grande, échelle d'une partie centrale du dispositif de la figure 8 et illustrent une préparation de l'accès de drain.
La figure 12 est une vue de dessus élargie du dispositif de la figure 11 et illustre une étape supplémentaire de l'accès de drain.
La figure 13 est une coupe schématique à plus grande échelle d'une partie centrale du dispositif de la figure 12 et illustre la fabrication d'un drain et de bornes de connexion de source de drain et de grille.
La figure 14 est une vue de dessus élargie du dispositif comparable au dispositif de la figure 13.
La figure 15 est une coupe schématique d'un substrat utilisé pour la fabrication d'un transistor fabriqué selon l'invention, selon un procédé constituant une variante au procédé illustré par les figures 1 à 14.
La figure 16 est une vue de dessus du dispositif de la figure 15.
La figure 17 est une coupe schématique à plus grande échelle d'une partie centrale du dispositif de la figure 16 sur lequel on a formé un empilement de couches.
La figure 18 est une vue de dessus élargie du dispositif de la figure 17 après une première gravure.
La figure 19 est une vue de dessus du dispositif de la figure 18 et illustre la formation d'un second masque de gravure.
La figure 20 est une coupe schématique à plus grande échelle d'une partie centrale du dispositif de la figure 19 et illustre la formation d'une colonne dans l'empilement de couches.
Les figures 21 à 24 sont des coupes schématiques du dispositif de la figure 19 et illustrent la réalisation de grilles isolées sur des flancs de la colonne.
La figure 25 est une coupe du dispositif de la figure 24 et illustre la formation d'un premier espaceur.
La figure 26 est une coupe du dispositif de la figure 25 et illustre une seconde gravure de la colonne.
La figure 27 est une coupe schématique du dispositif de la figure 26 et illustre une étape d'isolation et de protection d'une partie restante de la colonne.
La figure 28 est une vue de dessus élargie du dispositif de la figure 27.
La figure 29 est une vue de dessus du dispositif de la figure 28 et illustre une étape de formation d'un pavé sacrificiel.
La figure 30 est une coupe schématique à plus grande échelle d'une partie du dispositif de la figure 19 et illustre la formation d'espaceurs sur le pavé sacrificiel.
La figure 31 est une vue de dessus élargie du dispositif de la figure 30 et illustre le retrait du pavé sacrificiel.
La figure 32 est une coupe schématique à plus grande échelle d'une partie centrale du dispositif de la figure 31 et illustre une nouvelle gravure pour la formation de colonnettes dans la partie restante de la colonne.
La figure 33 est une coupe schématique du dispositif de la figure 32 et illustre un enrobage des colonnettes.
Les figures 34 à 36 sont des coupes schématiques du dispositif de la figure 33 et illustrent la préparation d'accès de grille sur les colonnettes.
La figure 37 est une coupe schématique du dispositif de la figure 36 et illustre la formation d'un drain.
La figure 38 est une vue de dessus élargie du dispositif de la figure 37 et illustre une étape d'isolation et de formation de bornes de contact.
La figure 39 est une vue de dessus du dispositif de la figure 30.
La figure 40 est une coupe schématique à plus grande échelle d'une partie centrale du dispositif de la figure 38 et illustre une gravure de la colonne selon une variante du procédé de la figure 32.
La figure 41 est une coupe schématique du dispositif de la figure 40 et illustre une étape d'enrobage de la partie restante de la colonne.
La figure 42 est une coupe schématique du dispositif de la figure 41 et illustre une gravure de colonnettes.

### Description détaillée de modes de mise en oeuvre de l'invention.

Dans la description qui suit, des parties identiques, similaires ou équivalentes des différentes figures sont repérées par les mêmes signes de référence pour faciliter le report entre les figures. Par ailleurs, et dans un souci de clarté des figures, tous les éléments ne sont pas représentés selon une échelle uniforme.

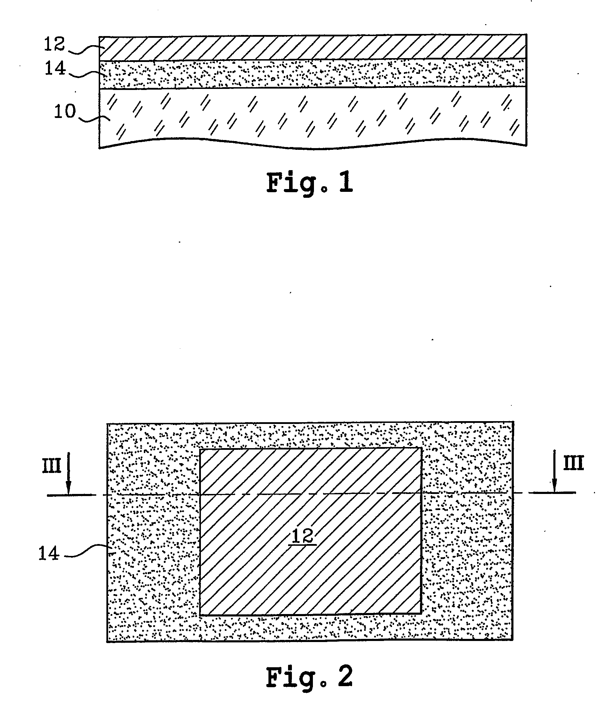

La figure 1 montre la structure d'un substrat utilisé pour la fabrication selon l'invention d'un transistor . Il s'agit d'un substrat de type SOI (Silicon On Insulator - silicium sur isolant).

Le substrat comporte une couche 10 de silicium massif, servant de support, et une couche superficielle de silicium monocristallin 12, dont l'épaisseur est de l'ordre de 1.à 200 nm. La couche superficielle 12 est reliée à la couche massive 10 par l'intermédiaire d'une couche enterrée d'isolant 14. La couche enterrée 14 est par exemple, une couche d'oxyde de silicium, et son épaisseur est de l'ordre de 10 à 400 nm.

La figure 2, qui est une vue de dessus du substrat de la figure 1 montre une première opération de gravure de la couche superficielle pour la délimiter et former ainsi une source du futur transistor. Dans la suite du texte la référence 12 est réservée à cette partie de la couche superficielle qui est désignée par « couche de source ».

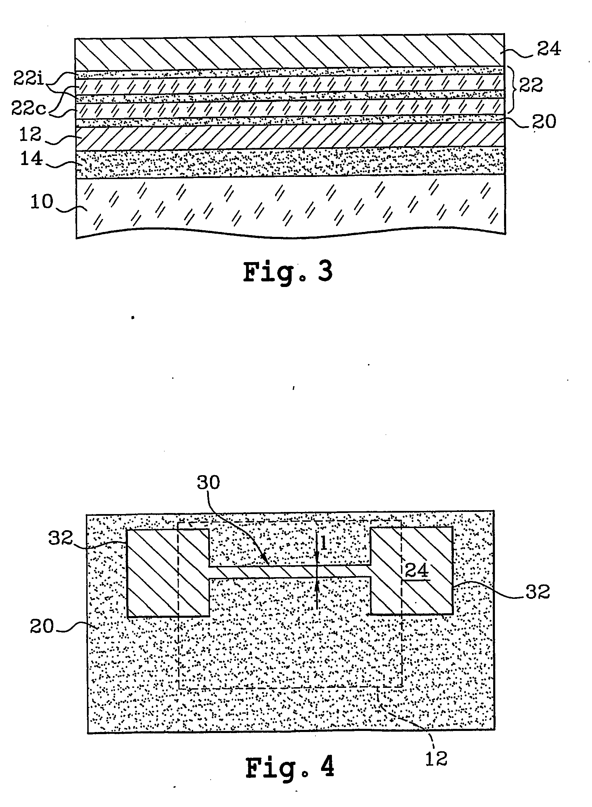

Comme le montre la figure 3, le procédé est poursuivi par la formation sur la couche de source 12 d'une couche mince d'isolant tunnel 20, d'un empilement alterné 22 de couches minces conductrices 22c, de couches minces isolantes 22i et d'une couche 24 dite de gabarit, également isolante. La couche de gabarit 24, dans cet exemple est une couche de nitrure de silicium.

Les couches minces 22c et 22i présentent, de même que la couche d'isolant tunnel 20 des épaisseurs de l'ordre du nanomètre. Il s'agit, par exemple, de couche de silicium, sous forme continue ou granulaire, alternant avec des couches d'oxyde de silicium. Le choix des matériaux et l'épaisseur des couches de l'empilement sont adaptés pour la formation ultérieure de boîtes quantiques. Ils sont suffisamment fins pour autoriser le passage d'électrons par effet tunnel lorsque le transistor est correctement polarisé.

Il convient de préciser que la figure 3, qui est une coupe selon un plan III-III indiqué sur la figure 2, ne représente pas l'ensemble du substrat de la figure 2, mais seulement une partie centrale qui se trouve être la partie coïncidant avec les limites de la couche de source 12.

La figure 4, est une vue de dessus du dispositif. Elle montre le résultat d'une première étape de lithographie et de gravure ultime. La gravure ultime, est prévue pour former dans l'empilement une languette filiforme 30. La languette 30 présente une largeur 1 dans un plan parallèle à la surface du substrat, qui est inférieure à 50 nm et de préférence de l'ordre de 5nm. Des largeurs aussi faibles peuvent être obtenues justement avec des motifs de gravure filiformes. Le motif est dicté par un masque de gravure, non représenté, mis en forme, de façon classique, par lithographie. La partie filiforme de l'empilement est délimitée par parties terminales élargies 32 dont la fonction est décrite ultérieurement.

La gravure ultime, anisotrope, est réalisée, dans cet exemple, avec arrêt sur la couche d'isolant tunnel 20. Il peut s'agir d'une gravure unique ou d'une gravure en plusieurs étapes, de façon à adapter les agents de gravure aux différentes couches à éliminer.

L'arrêt de gravure peut avoir lieu soit par un choix d'agents de gravure sélectifs c'est-à-dire des agents qui attaquent les matériaux des différentes couches avec des vitesses de réaction différentes, soit en ajustant les épaisseurs des couches. Ainsi une couche plus épaisse peut servir de couche d'arrêt de gravure d'une couche plus mince même si la sélectivité des agents de gravure n'est pas très bonne.

Dans le présent exemple, la couche d'isolant tunnel 20 n'est pas bien épaisse et ne constitue donc pas une très bonne couche d'arrêt de gravure. Toutefois, comme cela apparaît dans la suite du texte, le perçage de cette couche lors de la gravure n'est pas préjudiciable au bon fonctionnement du transistor.

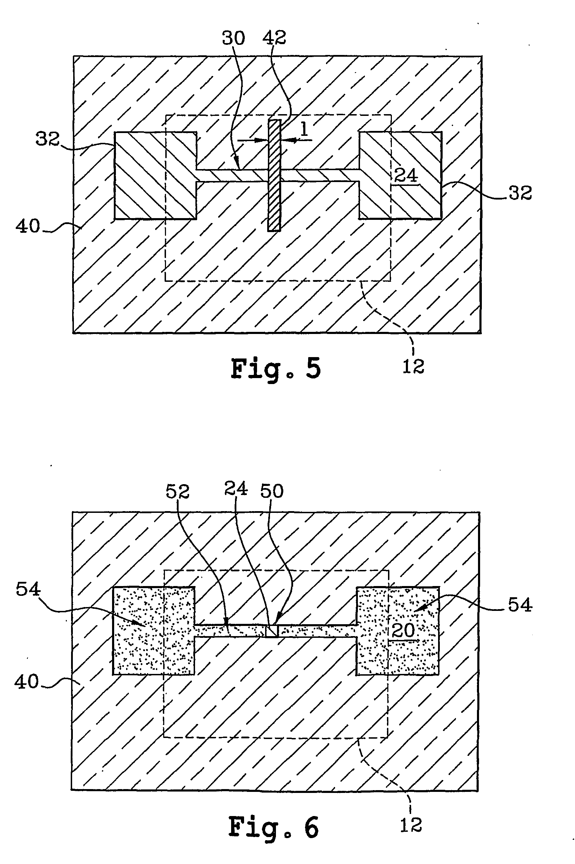

La figure 5 montre la formation d'une couche d'enrobage électriquement isolante 40. Il s'agit, par exemple, d'une couche de verre ou d'oxyde de silicium, déposée sur l'ensemble du substrat. Elle enrobe et recouvre de façon conforme la languette 30 qui vient d'être gravée dans l'empilement.

La couche d'enrobage est soumise à un planage, par exemple par polissage, avec arrêt sur la couche 24 de gabarit. Le planage permet d'obtenir une face supérieure plane à laquelle affleure la couche de gabarit, au sommet de l'empilement.

Une ligne en trait discontinu indique les limites de la couche de source 12.

Sur la face supérieure du dispositif, on forme ensuite, comme le montre également la figure 5, un second masque de gravure filiforme 42. Le masque 42, tout comme le masque qui a servi à graver précédemment la languette, est un masque filiforme, par exemple en résine, avec une largeur ne dépassant pas 50 nm. Le second masque de gravure est disposé de façon à croiser la languette filiforme 30 de l'empilement et, de préférence, de façon à la croiser en étant sensiblement perpendiculaire à celle-ci.

Après la formation du masque, le substrat est soumis à une seconde gravure ultime. La seconde gravure est également une gravure anisotrope sélective qui permet d'éliminer l'empilement en dehors de la petite région protégée par le second masque 42. L'empilement est encore gravé avec arrêt sur la couche d'isolant tunnel 20. La figure 6 montre le dispositif obtenu après le retrait du second masque de gravure.

De l'empilement de couches il ne reste qu'une colonnette 50. La colonnette 50 est disposée au milieu d'une gorge 52 dont les parois latérales sont formées par des flancs de la couche d'enrobage 40, mis a nu lors de la seconde gravure. Les gorges débouchent dans des puits 54, appelés encore puits de grille, dont l'emplacement correspond aux parties d'extrémité élargies de l'empilement

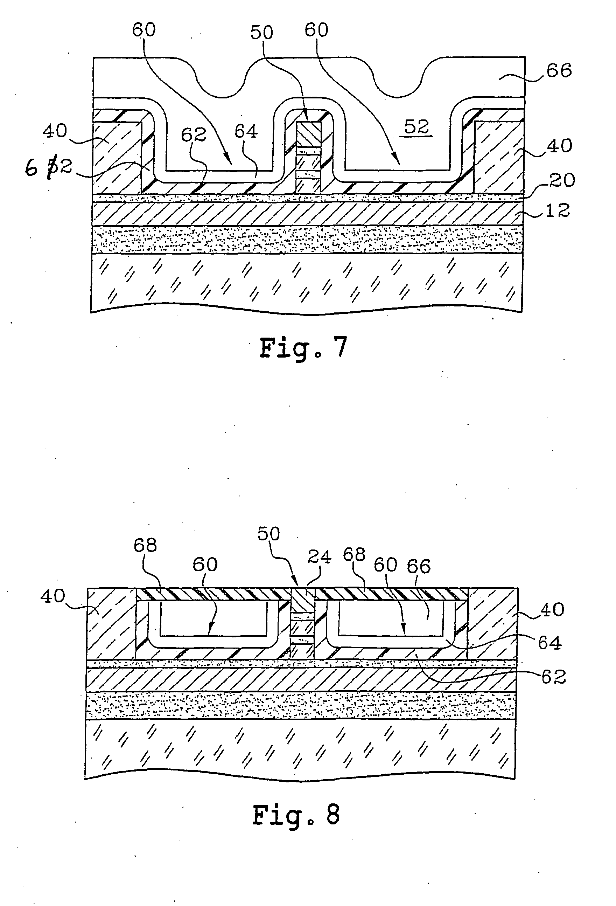

La figure 7 est une coupe du dispositif de la figure 6 le long de la gorge 52, et montre la formation de grilles isolées 60 dans la gorge. Pour des raisons de simplification et de clarté de la figure, la partie centrale est représentée à plus grande échelle. De même, la gorge 52 est représentée de façon raccourcie en ne tenant pas compte des puits de grille. Comme la gorge s'étend de part et d'autre de la colonnette, on peut considérer que le transistor possède deux grilles. On peut aussi considérer qu'il s'agit d'une grille unique en deux parties auxquelles on applique, ou non, des tensions de polarisation identiques lors du fonctionnement.

La formation de grilles isolées comprend le dépôt successif d'une couche d'isolant de grille 62, puis une ou plusieurs couches de matériau de grille. Dans l'exemple illustré, le dépôt de l'isolant de grille, par exemple de l'oxyde de silicium est suivi par la formation d'une couche conductrice additionnelle de matériau de grille, oxydable à basse température, par exemple de nitrure de titane 64 et d'une couche de silicium polycristallin 66. Le nitrure de titane permet d'augmenter la conductivité des grilles.

On peut retenir d'autres matériaux de grille oxydables à basse température: des matériau « Midgap » (TiN, W), des matériaux de type n⁺ (Sipoly, Nb) ou des matériaux de type p⁺ (Sipoly, Ni).

La couche additionnelle 64 n'est toutefois pas indispensable.

Le dépôt des couches est un dépôt conforme obtenu par exemple par un procédé de dépôt en phase vapeur (CVD). En d'autres termes les couches tapissent uniformément le fond de la gorge, recouvrent la colonnette 50 et viennent recouvrir la couche d'enrobage 40, dont une partie est représentée sur les bords de la figure.

L'épaisseur globale des couches est suffisante pour combler entièrement la gorge 52.

On peut noter que l'isolation électrique des grilles par rapport à la colonnette 50, mais aussi par rapport au fond de la gorge est assurée par la couche de matériau d'isolant de grille. Ainsi, lorsqu'une des gravures précédentes a percé la couche d'isolant tunnel au fond des gorges, c'est-à-dire si l'arrêt de gravure était insuffisamment sélectif, un court-circuit entre la couche de source 12 et les grilles est évité. Le fonctionnement du transistor n'est donc pas compromis.

La fabrication des grilles est suivie d'un planage des couches précédemment déposées. Il s'agit, par exemple, d'un polissage mécano-chimique effectué avec arrêt sur la couche d'enrobage et sur la couche de gabarit au sommet de la colonnette. Pour l'arrêt de planage des tampons d'arrêt (dummies), préalablement gravés dans l'empilement de couches, et surmontés de la couche de gabarit 24, peuvent éventuellement prévus en dehors de la région de fabrication du transistor pour faciliter l'arrêt de planage. De tels tampons ne sont pas représentés sur les figures.

La figure 8 montre les grilles obtenues au terme du planage. Elles affleurent au plan de la surface libre de la couche d'enrobage 40. Une couche superficielle 68 d'isolation électrique est formée à la surface des grilles. Il s'agit, par exemple, d'une couche d'oxyde obtenue par une oxydation des couches de matériau de grille 66, (et de la couche additionnelle 64).

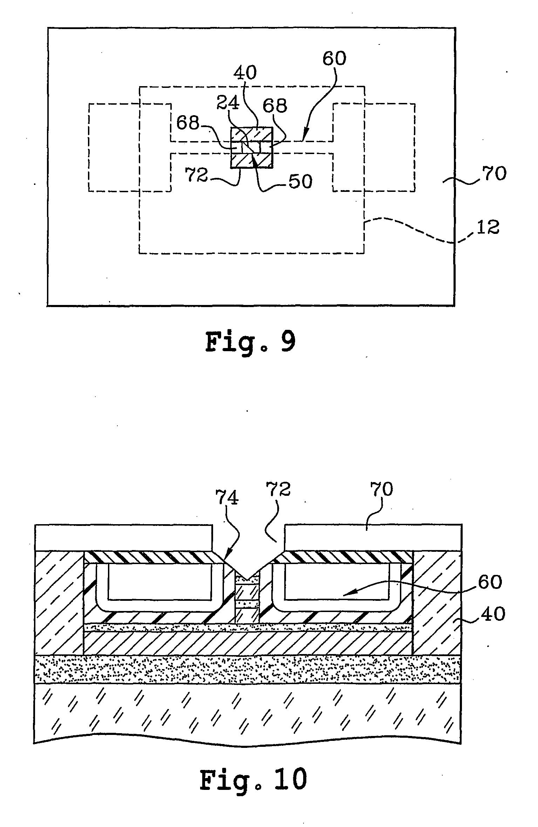

La figure 9 montre la formation d'un masque de gravure 70 sur la face libre du dispositif de la figure 8. Le masque de gravure 70, par exemple en résine, est mis en forme selon des techniques usuelles de lithographie pour y définir une ouverture 72. L'ouverture est sensiblement alignée sur la région du dispositif dans laquelle se trouve la colonnette 50. De préférence, l'ouverture présente des dimensions supérieures à celles de la colonnette parallèlement à la face libre du dispositif. Ainsi l'alignement de l'ouverture sur la colonnette n'est pas une opération critique.

La figure 10, qui est une coupe comparable à celle de la figure 8 permet de mieux voir la position relative de l'ouverture du masque 70 et de la colonnette 50. La colonnette est soumise à une gravure à travers l'ouverture du masque. La gravure permet d'éliminer la couche de gabarit (ref. 24 sur la fig.8) et tout ou partie d'une éventuelle couche sous-jacente d'isolant (22i fig.3).

On peut noter que l'élimination de la couche de gabarit peut aussi avoir lieu par une gravure sélective par rapport aux matériaux affleurant à la surface du dispositif, en l'occurrence la couche superficielle 68 d'isolation électrique des grilles et la couche d'enrobage 40. Dans ce cas l'étape de formation de masque, illustrée par la figure 9 est inutile.

Cependant l'utilisation du masque permet un choix plus libre des matériaux et des agents de gravure de la couche de gabarit. Selon le degré de sélectivité dans l'attaque des différentes couches, différentes formes de trou peuvent être obtenues. Dans certains cas, il peut être avantageux de réduire le rapport d'aspect du trou. Par exemple, une gravure des différents matériaux à des vitesses sensiblement équivalentes permet d'obtenir un facettage, c'est-à-dire la formation de facettes 74 sur les coins des grilles isolées, exposés dans l'ouverture du masque. Ceci apparaît à la figure 10.

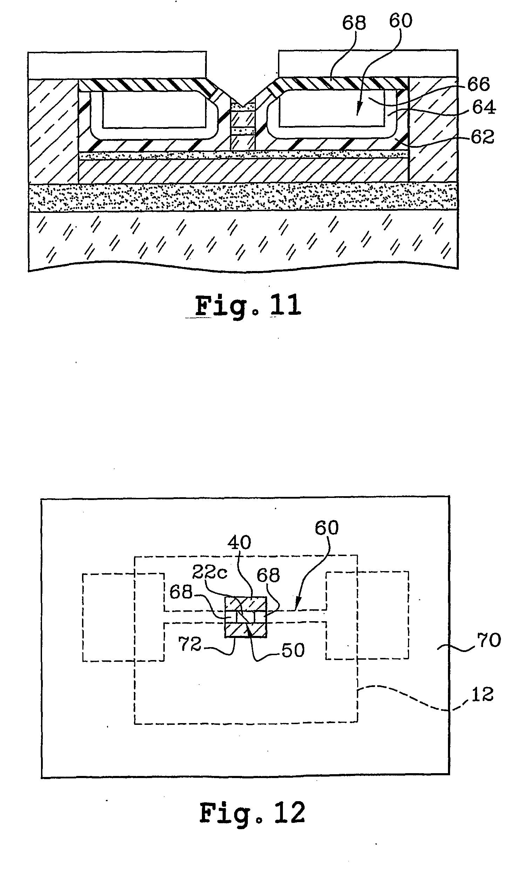

La figure 11 montre une étape supplémentaire facultative consistant à pratiquer une réoxydation des facettes aux coins des grilles isolées mises à nu. Cette opération permet d'éviter que les couches conductrices de la grille ne viennent à affleurement.

L'oxydation a lieu de préférence avant le retrait de la couche de gabarit 24. Par ailleurs, si la présence du masque 70 est avantageuse, elle n'est pas indispensable. On peut oxyder les matériaux des couches 62, 64, 60, 66 dans des conditions telles que les coins s'arrondissent avant d'éliminer la couche 24.

L'opération d'oxydation du matériau de grille peut avoir lieu avant la gravure de la couche de gabarit 24, par exemple dans le cas où la sélectivité par rapport aux autres matériaux est infinie (pas de facettage). Elle peut avoir lieu aussi après la gravure de la couche de gabarit 24, notamment lorsque la sélectivité n'est pas infinie. Enfin, l'oxydation peut avoir lieu avant et après la gravure de la couche de gabarit 24.

A titre indicatif, la figure 11 montre les limites des grilles isolées qui résulteraient d'une gravure parfaitement sélective de la couche de gabarit.

Une étape suivante, également facultative, illustrée par la figure 12 consiste à éliminer sélectivement une couche superficielle d'isolant sacrificiel au sommet de la colonnette, qui a été mise à nu par l'élimination préalable de la couche de gabarit. Cette étape de gravure sélective permet de mettre à nu une couche conductrice 22c de l'empilement de la colonnette 50.

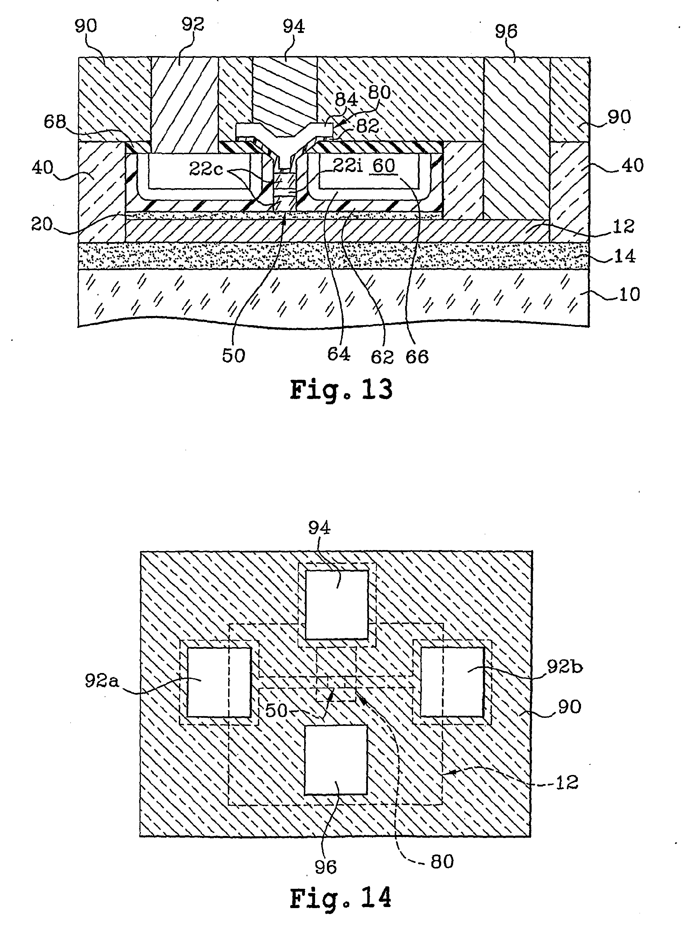

La figure 13 montre la formation d'un drain isolé 80 dans le puits ouvert par les gravures décrites en référence aux figures 9 à 12. Elle comporte le dépôt d'une couche d'isolant tunnel 82 en oxyde de silicium puis une couche conductrice 84, par exemple un métal. Ces couches sont mises en forme pour fixer l'extension du drain isolé au-dessus de la couche superficielle 68 d'isolation électrique.

Le fait de réaliser la jonction tunnel supérieure 82 après l'essentiel de la fabrication selon l'invention du transistor à blocage de Coulomb et non lors de la réalisation de l'empilement alterné 22, défini par les gravures croisées horizontales et verticales présentes respectivement aux figures 4 et 5 est important. Cela permet d'avoir un contrôle précis de l'épaisseur et de caractéristiques de cette jonction tunnel telles que sa qualité cristalline, ses qualités physico chimiques ainsi que l'interface. On ne risque pas d'induire des effets secondaires qui pourraient apparaître lors des étapes intermédiaires ayant lieu entre le dépôt des couches alternées de l'empilement (figure 3) et la réalisation de l'électrode supérieure 80 (figure 13). Les étapes postérieures à celles décrites à la figure 13 sont des étapes de fin de procédé qui mettent en jeu des températures plus faibles et qui induisent des effets secondaires moins importants.

Le procédé selon l'invention permet notamment de régler de manière fine l'épaisseur des jonctions tunnel.

Il est possible d'utiliser la couche superficielle d'isolant 22i de la colonnette comme isolant tunnel pour le drain. Toutefois, comme cette couche a déjà servi comme couche d'arrêt de gravure de la couche de gabarit, son épaisseur risque d'avoir été modifiée par une sur-gravure accidentelle. Le fait d'éliminer cette couche de la façon suggérée par la figure 12 et de la remplacer par la nouvelle couche d'isolant tunnel 82 permet de réduire le risque d'un contact accidentel direct entre le drain et un îlot de la colonnette.

A titre accessoire, la figure 13 montre également une « encapsulation » du transistor. Un matériau de recouvrement 90, tel que de l'oxyde de silicium non dopé, ou un verre borophosphosilicaté, est déposé sur le transistor de façon à entièrement recouvrir le drain 80. Le matériau subit ensuite un planage afin de rendre sa surface superficielle plane. Des puits d'accès sont gravés dans le matériau de recouvrement 90 à l'aplomb d'au moins une grille, du drain et d'une partie de la couche de source s'étendant au-delà de la colonnette. Les puits sont emplis d'au moins un matériau conducteur tel que W, TiN, Ti pour former des bornes d'accès aux grille, drain et source. Les bornes portent respectivement les références 92, 94 et 96 sur la figure 13.

La figure 14 est une vue de dessus du transistor après « encapsulation ». Il convient de noter que, pour en simplifier la représentation, la borne de connexion de source 96 a été ramenée dans le plan de coupe de la figure 13. La disposition réelle de cette borne est visible sur la figure 14.

La figure 14 qui correspond à une légère variante de réalisation du dispositif montre la borne de drain 94, la borne de source 96 et deux bornes de grille 92a et 92b. Les deux bornes de grille correspondent aux deux parties de grille de part et d'autre du canal. On peut également observer que la borne de drain 94 n'est pas nécessairement au-dessus du drain ou de la colonnette, mais peut être latéralement décalée. Enfin, les bornes de grille 92a et 92b ne sont pas formées sur les parties filiformes des grilles mais en leurs extrémités élargies.

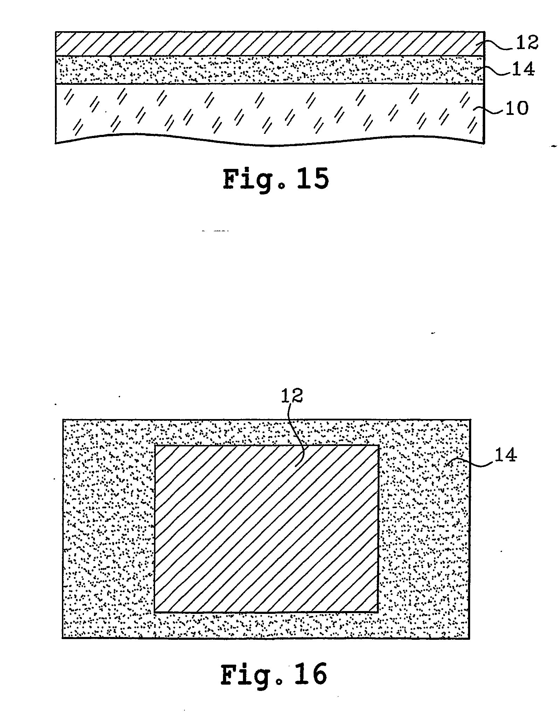

Les figures 15 et suivantes décrites ci-après illustrent une autre possibilité de fabrication selon l'invention d'un transistor à canal vertical et à blocage de coulomb.

Les étapes de fabrication illustrées par les figures 15, 16 et 17 sont identiques à celles déjà décrites en référence aux figures 1 à 3. On peut ainsi se reporter à la description qui précède.

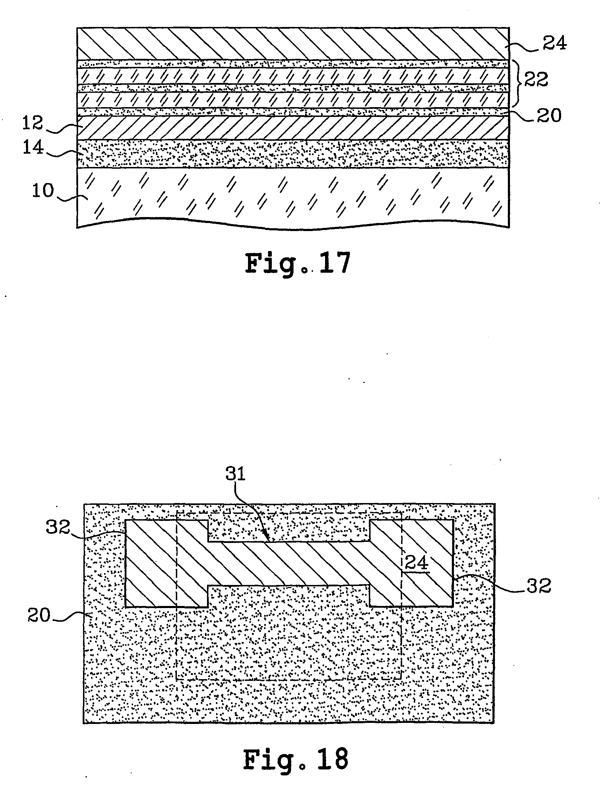

La figure 18, correspond à la figure 4. Elle illustre une première gravure de l'empilement de couches avec arrêt sur la couche d'isolant tunnel 20. Toutefois la première gravure n'est pas une gravure ultime dans le procédé illustré par la figure 18. On observe que la fine languette de l'empilement de la figure 4 se trouve être une bande 31 plus large sur la figure 18. La bande 18 présente une largeur comprise, par exemple, entre 100 et 300 nm. Ses extrémités, tout comme les extrémités de la languette de la figure 4 sont élargies. La partie superficielle de la bande 31, après l'élimination d'un masque de gravure non représenté, est formée par la couche de gabarit 24.

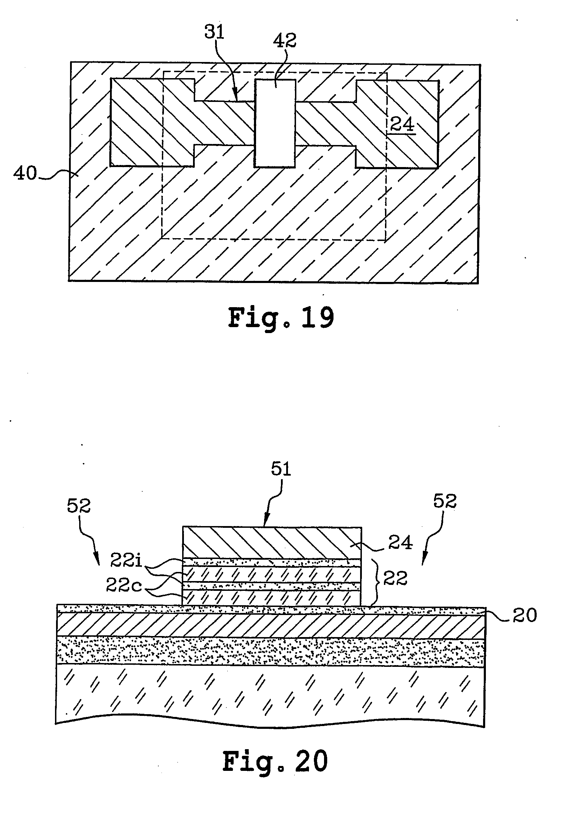

La figure 19 montre l'enrobage de l'empilement mis en forme après la première gravure. On observe la mise en place d'une couche d'enrobage 40 d'un matériau isolant électrique et la formation d'un second masque de gravure 42. Ce second masque, est également plus large que le second masque décrit en référence à la figure 5. Sa largeur est du même ordre de grandeur que celle de la bande 31 formée dans l'empilement.

Une deuxième gravure, qui n'est pas une gravure ultime, permet de former une colonne 51 dont l'emplacement correspond à l'intersection du second masque avec la bande 31. A l'exception de ses dimensions la colonne 51 est tout à fait comparable à la colonnette 50 décrite en référence aux figures 6 et 7.

La figure 20 qui est une coupe schématique d'une partie centrale du dispositif de la figure 19, montre, à plus grande échelle, la colonne 51. La colonne 51 comporte un empilement alterné 22 de couches isolantes 22i et « conductrices » 22c et la couche de gabarit 24. La couche d'isolant 22i qui se trouve juste sous la couche de gabarit est une couche sacrificielle qui peut éventuellement être remplacée dans la suite du procédé par une nouvelle couche d'isolant tunnel.

La référence 52 désigne toujours une gorge qui s'étend de part et d'autre de la colonne 51.

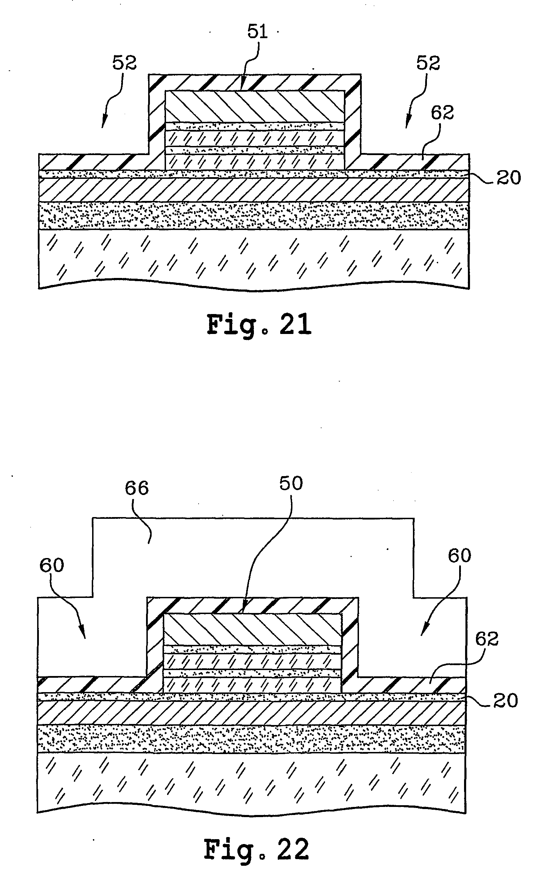

La figure 21 illustre le dépôt d'une couche d'isolant de grille 62 qui recouvre de façon conforme la colonne 51 et la couche d'isolant tunnel 20 au fond des gorges. Il s'agit, par exemple d'une couche d'oxyde de silicium avec une épaisseur de l'ordre de 8 nm. Tout comme la couche d'isolant de grille 62 visible sur la figure 7, elle permet de parer à un éventuel défaut ou une sur-gravure de la couche d'isolant tunnel 20.

Le dépôt de la couche d'isolant de grille 62 est poursuivi par celui d'un ou plusieurs matériaux de grille. Dans l'exemple de la figure 22, une couche 66 de nitrure de titane, de silicium polycristallin ou d'un autre matériau de grille de type « Midgap », N⁺ ou P⁺ est déposée. A l'instar du procédé décrit en référence à la figure 7, deux ou plusieurs couches conductrices ou semi-conductrices peuvent également former la grille 60.

Comme le montre la figure 22, l'épaisseur totale des couches déposées pour la formation de grilles isolées est suffisante pour entièrement combler la gorge 52.

Un planage, opéré, par exemple, par polissage mécano-chimique, est prévu pour conférer à la structure une surface supérieure plane à laquelle affleure la couche de gabarit 24 en nitrure de silicium. Celle-ci se situe au sommet de la colonne 51. La couche de gabarit, de même que d'éventuels tampons d'arrêt non représentés, servent d'arrêt de planage, de sorte que la couche d'isolant de grille soit éliminée au-dessus de la couche de gabarit.

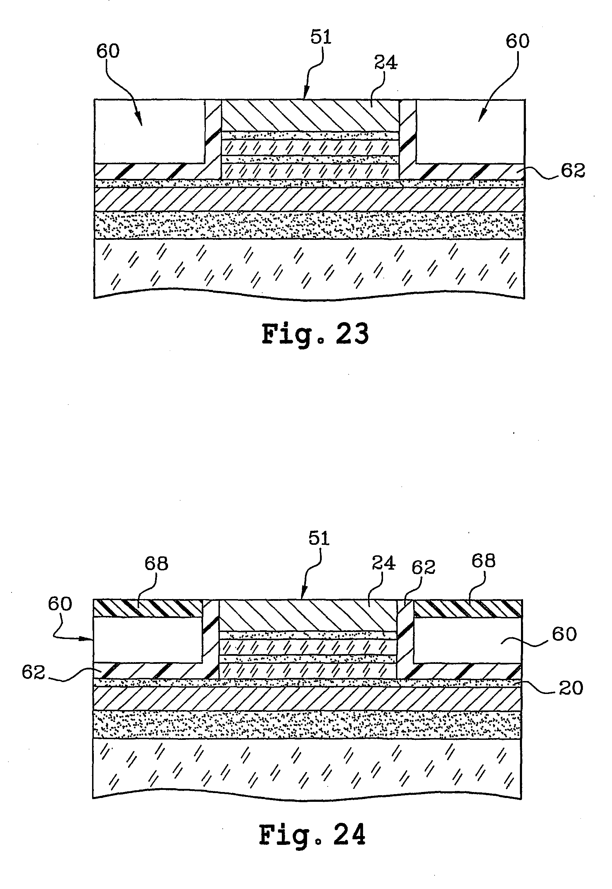

La figure 24 montre la formation d'une couche superficielle 68 d'isolation électrique à la surface des grilles 60. Celle-ci peut être formée simplement par oxydation superficielle du matériau des grilles.

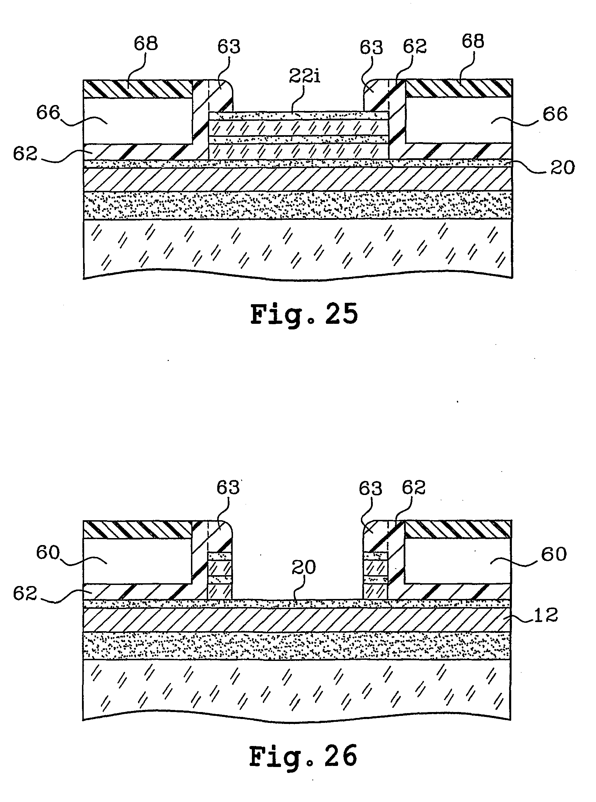

La figure 25 montre une étape consistant à éliminer la couche de gabarit au-dessus de la colonne 51 par une gravure sélective. Cette gravure met à nu une couche superficielle isolante 22i de l'empilement, encore considérée comme sacrificielle.

Suite à la gravure, des espaceurs 63 sont formés sur des flancs de la couche d'isolant de grille 62. Il s'agit de flancs surplombant la couche isolante superficielle 22i, et dégagés lors de l'élimination de la couche de gabarit.

La formation des espaceurs comprend, de façon classique, le dépôt d'un matériau isolant électrique, tel que de l'oxyde de silicium, par exemple, puis la gravure anisotrope de ce matériau jusqu'à l'éliminer entièrement sur des faces parallèles aux couches du substrat.

L'extension latérale des espaceurs 63 au-dessus de la colonne 51 peut être ajustée à des valeurs très faibles, de l'ordre de quelques nanomètres. Ce faible recouvrement est utilisé comme un masque de gravure pour une gravure anisotrope ultime.

Le résultat de la gravure ultime, effectué dans cet exemple, avec arrêt sur la couche d'isolant tunnel 20 qui recouvre la couche de source 12, est illustré par la figure 26. L'extension latérale des espaceurs 63 est choisie juste suffisante pour ne pas éliminer entièrement les couches de l'empilement sous les espaceurs. La partie restante de la colonne sous les espaceurs est comparable à deux petits murets qui sont vus en coupe sur la figure 26.

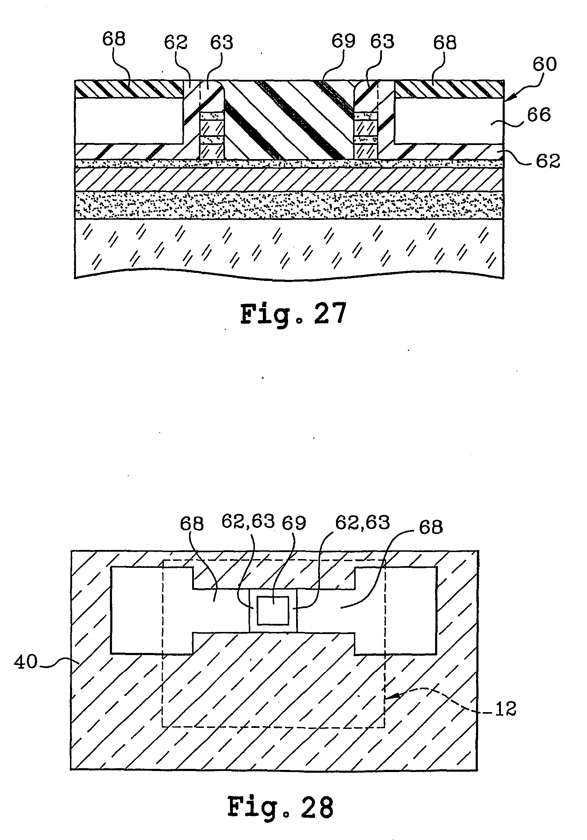

La dépression formée entre les grilles par la gravure est comblée par un bloc de matériau isolant représenté à la figure 27. Il s'agit de préférence d'un bloc d'oxyde, tel que de l'oxyde de silicium formé par dépôt puis planage.

La figure 28 est une vue de dessus, plus globale, qui permet de mieux voir la disposition relative du matériau d'enrobage 40, de la couche superficielle d'isolant 68 recouvrant les grilles, le bloc d'oxyde 69 et la couche d'isolant de grille 62 flanquée des espaceurs 63.

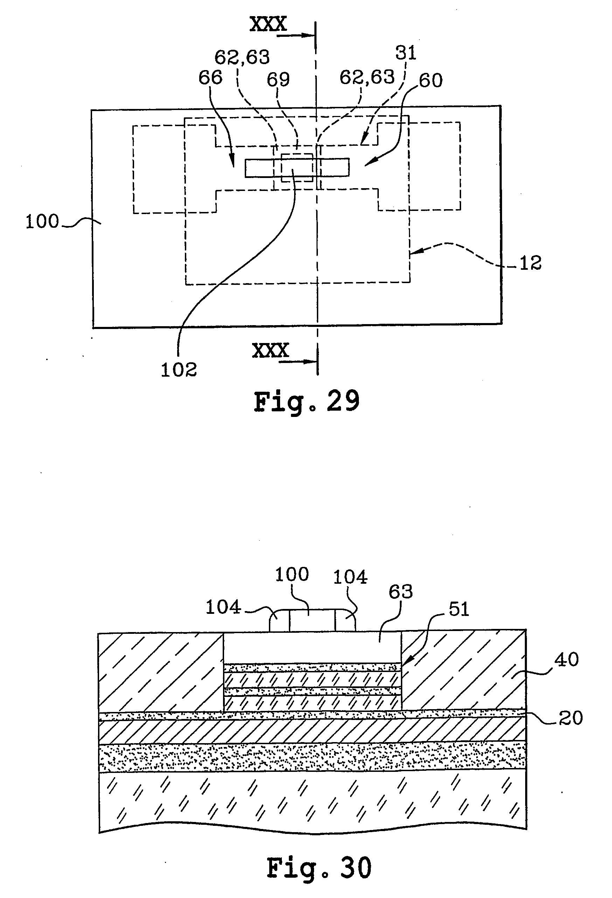

La figure 29 montre la formation sur la face supérieure du dispositif de la figure 28 d'une couche sacrificielle 100. Il s'agit par exemple d'une couche de polysilicium.

Un masque de résine 102 est formé sur la couche sacrificielle. Il s'agit d'un masque s'étendant de part et d'autre du bloc d'oxyde 69, et des espaceurs 63, jusqu'au-dessus des grilles 60. Le masque 102, est de préférence centré par rapport à l'extension des espaceurs 63 perpendiculairement à la bande 31. Il est en outre légèrement moins large que la bande 31 mentionnée en référence à la figure 20, c'est-à-dire légèrement moins large que les espaceurs 63.

Le masque de résine est utilisé comme masque de gravure pour mettre en forme la couche sacrificielle 100.

Au terme de la gravure de la couche sacrificielle, on obtient un pavé sacrificiel qui est repéré avec la même référence 100 que la couche pour des raisons de commodité.

La figure 30 est une coupe XXX-XXX du dispositif de la figure 29 le long d'un espaceur 63. Elle permet de voir le reliquat de la colonne 51, c'est-à-dire le muret de l'empilement initial restant sous l'espaceur, et la position relative du pavé sacrificiel 100. Le pavé sacrificiel est vu ici en coupe après l'élimination du masque de résine.

On observe encore sur la figure 30 que les flancs latéraux du pavé sont également garnis d'espaceurs 104. Il s'agit, par exemple d'espaceurs avantageusement d'oxyde de silicium, de SiC ou de TiN, formés également par dépôt puis gravure anisotrope du matériau. Les dimensions du pavé sont ajustées de sorte que les espaceurs 104 du pavé soient disposés au-dessus des espaceurs 63 de l'isolant de grille en les croisant.

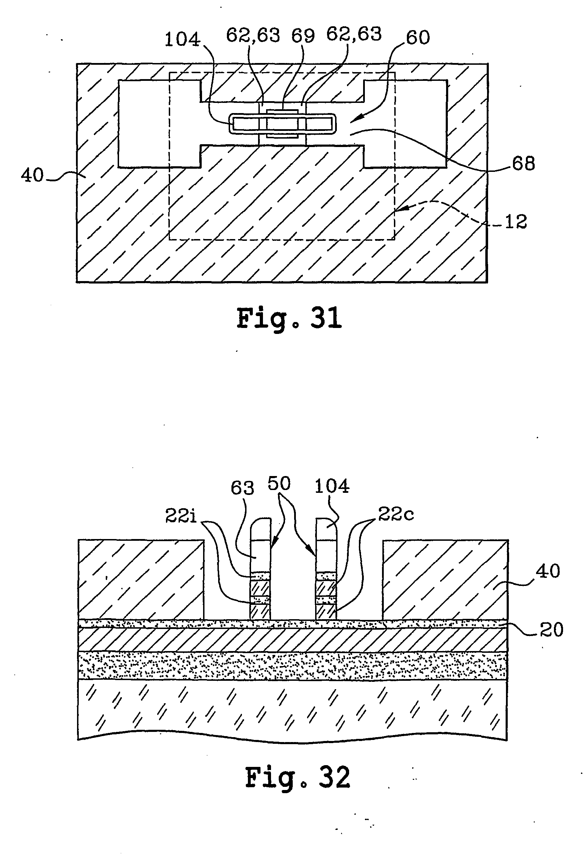

La figure 31, qui est une vue de dessus du dispositif après l'élimination sélective du pavé sacrificiel permet de mieux voir le croisement des espaceurs 63 et 104.

Après l'élimination du pavé sacrificiel, on procède à une nouvelle gravure sélective des couches de l'empilement, et plus précisément du reliquat de la colonne 51, en utilisant les espaceurs 104 du pavé sacrificiel comme masque de gravure. Lors de cette gravure les parties non protégées des espaceurs 63 de la couche d'isolant de grille sont également éliminées. La couche d'enrobage 40 est toujours maintenue. Le résultat de cette gravure est visible sur la figure 32 qui correspond au même plan de coupe que la figure 30. Elle permet de libérer quatre colonnettes 50 dont seules deux sont visibles sur la figure.

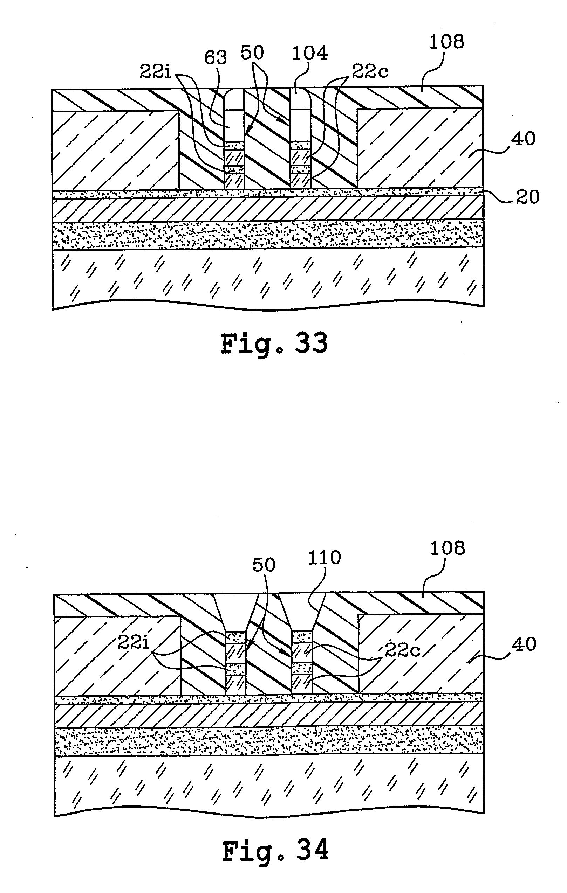

Un dépôt d'oxyde 108 suivi de son planage permet de consolider les colonnettes tout en assurant leur isolation électrique. Ces opérations sont illustrées par la figure 33.

La figure 34 illustre une gravure sélective permettant d'éliminer l'espaceur 104 du pavé sacrificiel et la partie sous-jacente de l'espaceur 63 de la couche d'isolant de grille. Une sélectivité limitée de la gravure permet d'obtenir des puits évasés 110 au-dessus des colonnettes 50.

Comme dans le précédent mode de réalisation, il est préférable de contrôler avec précision l'épaisseur de la couche d'isolant tunnel qui sépare le drain du canal.

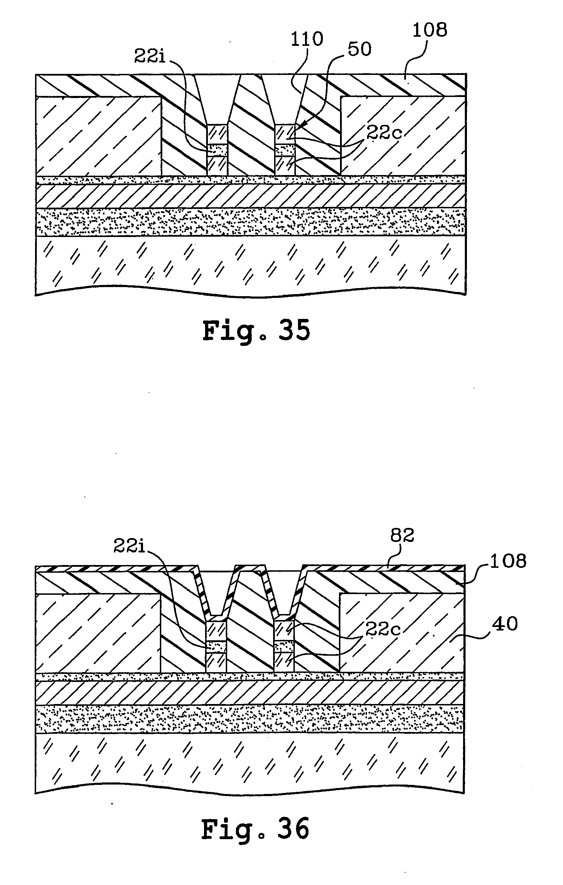

A cet effet, on élimine dans l'empilement de la colonnette une éventuelle couche superficielle d'isolant pour mettre à jour une des couches minces conductrices 22c. Dans l'exemple illustré, il s'agit d'éliminer, comme lé montre la figure 35, la couche d'isolant se trouvant au sommet de l'empilement et considérée comme sacrificielle. On peut noter que, lorsque la dernière couche isolante au sommet des colonnettes est destinée à être remplacée, il est possible de la prévoir un peu plus épaisse que les autres couches de l'empilement, pour en faire une meilleure couche d'arrêt de gravure pour la formation des puits 110.

La figure 36 montre le dépôt d'une nouvelle couche d'isolant tunnel 82 dont l'épaisseur est parfaitement contrôlée pour former une jonction tunnel au-dessus de la couche conductrice 22c des colonnettes, précédemment mise à jour. La couche d'isolant tunnel, par exemple une couche de SiO₂ s'étend dans les puits évasés et, le cas échéant, sur la couche d'oxyde 108 formée pour la consolidation mécanique des colonnettes 50.

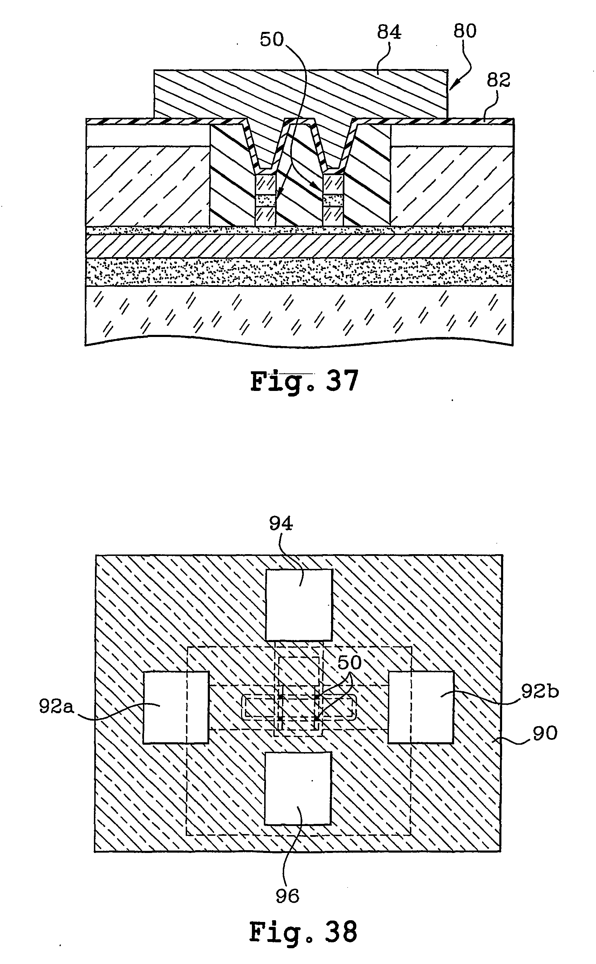

La figure 37 montre la formation d'un drain par dépôt puis mise en forme d'une couche conductrice 84.

L'ensemble constitué de la couche d'isolant tunnel 82 et de la couche conductrice 84 constitue un drain isolé repéré par la référence 80, par analogie avec la figure 13.

Dans l'exemple illustré, un drain isolé unique est associé aux quatre canaux de transistor correspondant aux quatre colonnettes 50. Il est toutefois possible de scinder le drain en deux ou en quatre drains mutuellement isolés pour constituer quatre transistors à source commune. Une même grille reste cependant associée chaque fois à deux canaux, donc à deux transistors.

La figure 38, comparable à la figure 14 précédemment décrite montre le transistor obtenu après « encapsulation » sous une couche de recouvrement (90).

On peut observer une borne de drain 94 connectée aux quatre colonnettes 50, une borne de grille 92a associée à la grille des colonnettes de gauche sur la figure, une borne de grille 92b associée à la grille des colonnettes de droite sur la figure, et une borne de connexion de source 96.

On décrit à présent une variante du procédé ci-dessus qui reprend à l'identique toutes les étapes décrites en référence aux figures 15 à 30.

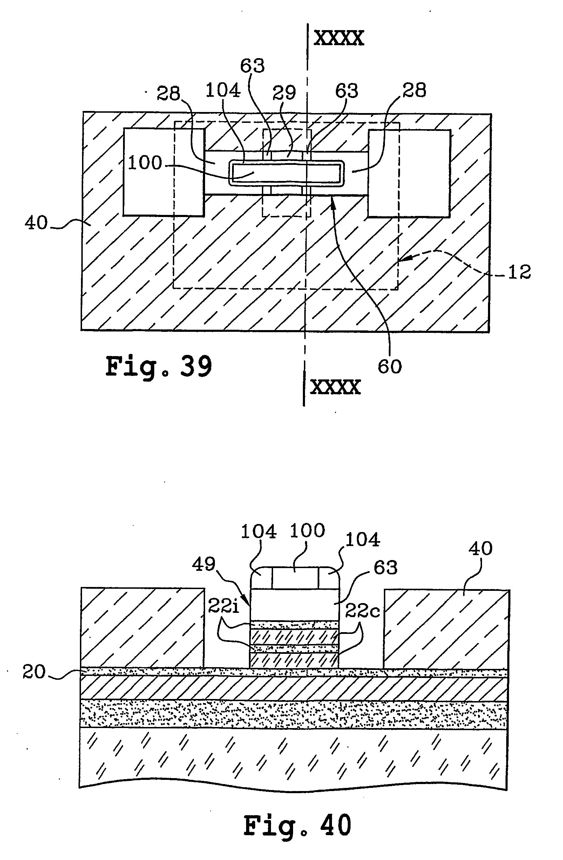

La figure 39 est une vue de dessus du dispositif de la figure 31. Elle montre que le pavé sacrificiel 100 n'est pas éliminé, contrairement au procédé de la figure 32.

Une gravure sélective anisotrope de la partie restante de la colonne a lieu en utilisant le pavé sacrificiel 100 et les espaceurs latéraux 104 du pavé comme masques de gravure. La gravure, avec arrêt sur la couche d'isolant tunnel 20, permet de découper un muret 49 dans l'empilement restant comme le montre la figure 40. La figure 40 est une coupe XXX-XXX du dispositif de la figure 39 le long de l'un des espaceurs 63.

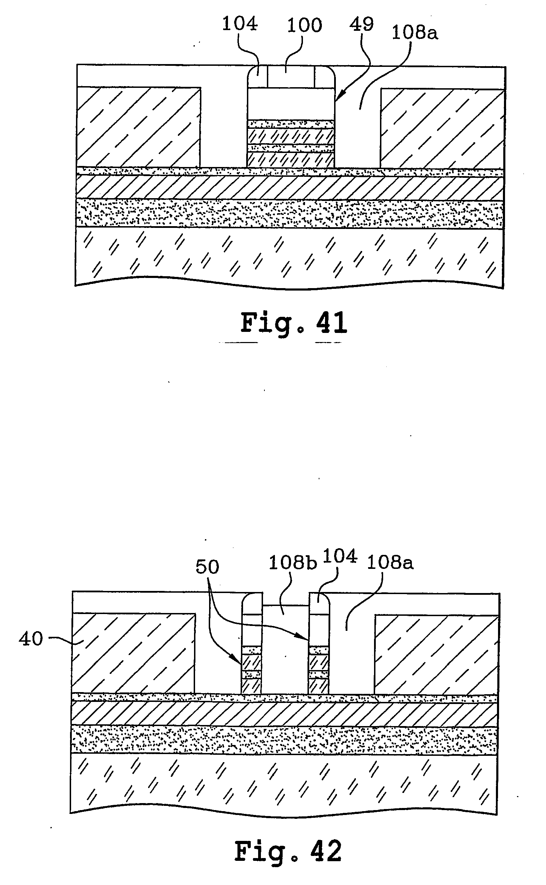

La figure 41 montre la consolidation du muret par une couche d'isolant 108a, par exemple d'oxyde. Cette opération est suivie par l'élimination du pavé sacrificiel et par une nouvelle gravure anisotrope sélective. La deuxième gravure utilise seulement les espaceurs 104 du pavé sacrificiel 100 comme masque de gravure. On obtient alors des colonnettes 50 identiques à celles des figures 32 et 33.

Ces colonnettes sont, comme le montre la figure 42 consolidées par une nouvelle couche isolante 108b. Les couches 108a et 108b ont finalement la même fonction que la couche 108 de la figue 33.

La variante décrite ici, et qui revient à graver les colonnettes en deux étapes avec un renforcement mécanique intermédiaire, permet de réduire grandement le risque d'une rupture accidentelle des colonnettes qui par construction ont une faible section.

### DOCUMENTS CITES

(1) "Fabrication and electron transport in multilayer silicon-insulator-silicon nanopillars" David M. Pooley and Haroon Ahmed J. Vacc. Sci. Technol. B 17(N°6), Nov/Dec 1999, pp. 3235-3238
(2) "Enhancement of Coulomb Blockade and tunability by multidot coupling in a silicon-on-insulator-based single-electron transistor" J.W. Park, K.S. Park, B.T. Lee, C.H. LEE, S.D. Lee and Jung B. Choi APPLIED PHYSICS LETTERS, Vol. 75, n° 4, 26 JULY 1999, pp. 566-568
(3) "Coulomb Blockade in silicon nano-pillars" D.M. Pooley and H. Ahmed APPLIED PHYSICS LETTERS, vol. 74, n° 15, 12 April 1999, pp.2191-2193

## Revendications

1. Procèdé de fabrication d'un transistor à blocage de Coulomb comprenant sur un substrat :
- un empalement de couches de canal (22, 22i, 22c) formant au moins une boîte quantique,
- une source (12) et un drain (80, 82, 84) connectés à la boîte quantique par l'intermédiaire de jonctions tunnel dont au moins une est distinct des couches de l'empilement, et empilés avec les couches de canal, au moins une grille (60) en regard d'au moins un flanc de l'empilement,
- l'empilement de couches comprenant au moins un îlot conducteur nanométrique (22c) disposé entre des couches électriquement isolantes (22i),
le procédé comprenant les étapes successives suivantes:
- le dépôt sur un substrat isolant d'une couche de source (12), d'une couche d'isolant tunnel (20) et un empilement alterné d'au moins une couche conductrice (22c) et d'au moins d'une couche isolante (22i),
- une première gravure de l'empilement pour former une languette filiforme (30),
- l'enrobage de la languette filiforme avec un matériau d'enrobage (40) isolant électrique,
- une deuxième gravure de la languette de l'empilement pour former une colonnette (50), la deuxième gravure préservant le matériau d'enrobage (40) pour définir une gorge (52) s'étendant de part et d'autre de la colonnette. (50) .
- la formation d'au moins une grille isolée (60) dans la gorge (52),
- la formation d'un drain (84) en contact avec une extrémité de la colonnette opposée à la couche de source, par l'intermédiaire d'au moins une couche d'isolant tunnel (82).

2. Procédé selon la revendication 1, comprenant en outre la formation de bornes de connexion (92a, 92b, 94, 96) sur la couche de source, sur la grille, et sur le drain.

3. Procédé selon la revendication 1, dans lequel la formation de la grille isolée comprend le dépôt dans la gorge (52) d'un matériau d'isolant de grille (62), et d'un matériau de grille (66), puis le planage de ces couches avec arrêt sur la colonnette.

4. Procédé selon la revendication 3, dans lequel on effectue la première gravure selon une couche de gabarit (24) et on conserve au moins une portion de la couche de gabarit (24) sur la colonnette lors de la deuxième gravure, et dans lequel le planage a lieu avec arrêt sur la portion de couche de gabarit.

5. Procédé de fabrication d'un transistor à blocage de Coulomb comprenant sur un substrat :
- un empilement de couches de canal (22, 22i, 22c) formant au moins une boîte quantique,
- une source (12) et un drain (80) connectés à la boite quantique par l'intermédiaire de jonctions tunnel dont au moins une est distincte des couches de l'empilement, et empilés avec les couches de canal,
- au moins une grille (60) en regard d'au moins une flanc de l'empilement,
- l'empilement de couches de canal comprenant au moins un îlot conducteur nanométrique (22c) disposé entre des couches électriquement isolantes (22i).
le procédé comprenant les étapes successives suivantes :
- le dépôt sur un substrat isolant d'une couche de source (12), d'une couche d'isolant, tunnel (26) et un empilement alterné d'au moins une couche conductrice (22c) et d'au moins d'une couche isolante (22i),
- une première gravure de l'empilement selon un couche de gabarit (24) pour former une bande (31),
- l'enrobage de la bande avec un matériau d'enrobage (40) isolant électrique,
- une deuxième gravure de la bande (31) de l'empilement pour former une colonne (51), la deuxième gravure préservant le matériau d'enrobage (40) pour définir une gorge (52) de part et d'autre de la colonne (51), et la deuxième gravure préservant une partie de la couche de gabarit (24) sur la colonne (51),
- la formation d' au moins une grille isolée (60) dans la gorge (S2),
- le retrait de la couche de gabarit (24) pour dégager une partie de la grille isolée et la formation contre la grille isolée d'au moins un espaceur (63) s'étendant partiellement sur la colonne (51),
- la gravure de la colonne (51), en utilisant l'espaceur (63) comme masque de gravure, de façon a préserver au moins une partie de la colonne (51) disposée sous l'espaceur,
- le découpage de colonnettes (50) dans la partie préservée de la colonne,
- l'isolation des colonnettes, et
- la formation d'au moins un drain (84) en contact avec au moins une extrémité d'une colonnette, opposée à la couche de source, par l'intermédiaire d'au moins une couche d'isolant tunnel (82).

6. Procédé sillon la revendication 5, dans lequel le découpage des colonnettes (50) comprend:
- la formation au-dessus de la partie préservée de la colonne, d'un pavé sacrificiel (100) de matériau de masque, avec au moins un flanc disposé au-dessus d'un bord d'au moins une colonnette devait être formée,
- la formation d'au moins un espaceur (104) sur le flanc du pavé sacrificiel (100),
- la gravure de la partie préservée de la colonne (51), en utilisant l'espaceur du pavé sacrificiel, comme masque de gravure, pour préserver au moins une colonnette (50) sous cet espaceur.

7. Procédé selon la revendication 6, dans lequel la gravure de la partie préservée de la colonne (51) est précédée par l'élimination du pavé sacrificiel (100).

8. Procédé selon la revendication 6, dans lequel la gravure de la partie préservée de la colonne comprend :
- une première gravure en utilisant le pavé sacrificiel (100) et l'espaceur (104) du pavé comme masque de gravure,
- la consolidation de la partie restante de la colonne par un matériau isolant électrique (108a),
- l'élimination du pavé sacrificiel (100), en préservant l'espaceur (104) du pavé sacrificiel, et
- une deuxième gravure en utilisant l'espaceur (104) du pavé sacrificiel comme masque, pour définir au moins une colonnette (50).

## Claims

1. Process for manufacturing a Coulomb blockade transistor comprising the following on a substrate:
- a stack of channel layers (22, 22i, 22c) forming at least one quantum box,
- a source (12) and a drain (80, 82, 84) connected to the quantum box through tunnel junctions, at least one of which is distinct from the layers of the stack, and stacked with the channel layers,
- at least one grid (60) facing at least one flank of the stack,
- the stack of layers comprising at least one nanometric conducting island (22c) arranged between the electrically insulating layers (22i),
the process comprising the following steps in sequence:
- deposition on an insulating substrate of a source layer (12), a tunnel-insulating layer (20) and an alternating stack of at least one conducting layer (22c) and at least one insulating layer (22i),
- a first etching of the stack to form a filiform tab (30),
- coating of the filiform tab with an electrically insulating coating material (40),
- a second etching of the tab of the stack to form a pillar (50), the second etching preserving the coating material (40) to define a groove (52) on each side of the pillar (50),
- the formation of at least one isolated grid (60) in the groove (52),
- the formation of a drain (84) in contact with one end of the pillar opposite the source layer, through at least one tunnel-insulating layer (82).

2. Process according to claim 1, also including the formation of connection terminals (92a, 92b, 94, 96) on the source layer, the grid, and the drain.

3. Process according to claim 1, in which formation of the isolated grid includes deposition of a grid-insulating material (62), and a grid material (66) in the groove (52), and then masking these layers plane and stopping on the pillar.

4. Process according to claim 3, in which the first etching is done following a template layer (24) and at least one portion of the template layer (24) is kept on the pillar during the second etching, and in which planing takes place on the portion of the template layer.

5. Process for manufacturing a Coulomb blockade transistor comprising the following on a substrate:
- a stack of channel layers (22c, 22i, 22c) forming at least one quantum box,
- a source (12) and a drain (80) connected to the quantum box through tunnel junctions, at least one of which is distinct from the layers of the stack, and stacked with the channel layers,
- at least one grid (60) facing at least one flank of the stack,
- the stack of channel layers comprising at least one nanometric conducting island (22c) arranged between electrically insulating layers (22i).
the process comprising the following steps in sequence:
- deposition of a source layer (12), a tunnel-insulating layer (26) and an alternating stack of at least one conducting layer (22c) and at least one insulating layer (22i), on an insulating substrate,
- a first etching of the stack according to a template layer (24) to form a strip (31),
- coating of the strip with an electrically insulating coating material (40),
- a second etching of the strip (31) in the stack to form a column (51), the second etching preserving the coating material (40) to define a groove (52) on each side of the column (51), and the second etching protecting a part of the template layer (24) on the column (51),
- formation of at least one isolated grid (60) in the groove (52),
- withdrawal of the template layer (24) to expose part of the isolated grid and formation of at least one spacer (63) extending partially onto the column (51), in contact with the isolated grid,
- etching of the column (51), using the spacer (63) as an etching mask, so as to preserve at least part of the column (51) located under the spacer,
- cutting of pillars (50) in the preserved part of the column,
- isolating the pillars, and
- formation of at least one drain (84) in contact with at least one end of a pillar, opposite the source layer, through at least one tunnel-insulating layer (82).

6. Process according to claim 5, in which cutting of pillars (50) includes:
- formation of a sacrificial pad (100) of mask material above the preserved part of the column, with at least one flank located above an edge of at least one pillar to be formed,
- formation of at least one spacer (104) on the flank of the sacrificial pad (100),
- etching of the preserved part of the column (51), using the spacer of the sacrificial pad as an etching mask, to preserve at least one pillar (50) under the spacer.

7. Process according to claim 6, in which the sacrificial pad (100) is eliminated before etching of the preserved part of the column (51).

8. Process according to claim 6, in which etching of the preserved part of the column comprises:
- a first etching using the sacrificial pad (100) and the spacer (104) of the pad as the etching mask,
- consolidation of the remaining part of the column by an electrically insulating material (108a),
- elimination of the sacrificial pad (100), preserving the spacer (104) of the sacrificial pad, and
- a second etching using the spacer (104) of the sacrificial pad as a mask to define at least one pillar (50).

## Patentansprüche

1. Verfahren zur Herstellung eines Coulomb-Blockade-Transistors, der auf einem Substrat aufweist:
- eine Übereinanderschichtung von Kanalschichten (22, 22i, 22c), wobei mindestens ein Quantenpunkt gebildet wird,
- einen Source (12) und einen Drain (80, 82, 84), die mit dem Quantenpunkt über dazwischenliegende Tunnelübergänge verbunden sind, von denen mindestens einer verschieden von den übereinandergeschichteten Schichten ist, und die mit den Kanalschichten übereinandergeschichtet sind.
- mindestens ein Gate (60) gegenüberliegend mindestens einer Flanke der Übereinanderschichtung,
- wobei die Übereinanderschichtung von Schichten mindestens eine leitende Insel (22c) im Nanometergrößenbereich aufweist, die zwischen den elektrisch isolierenden Schichten (22i) angeordnet ist,
wobei das Verfahren die folgenden aufeinanderfolgenden Schritte umfasst:
- das Ablagern, auf einem isolierenden Substrat, einer Source-Schicht (12), einer Tunnel-Isolierschicht (20) und einer abwechselnden Übereinanderschichtung mindestens einer leitenden Schicht (22c) und mindestens einer isolierenden Schicht (22i),
- ein erstes Ätzen der Übereinanderschichtung, um eine fadenförmige Zunge (30) zu bilden,
- das Umhüllen der fadenförmigen Zunge mit einem elektrisch isolierenden Umhüllungsmaterial (40),
- ein zweites Ätzen der Zunge der Übereinanderschichtung, um ein Säulchen (50) zu bilden, wobei beim zweiten Ätzen das Umhüllungsmaterial (40) erhalten bleibt, um eine Auskehlung (52) zu definieren, die sich beiderseits des Säulchens (50) erstreckt,
- das Ausbilden mindestens eines isolierten Gate (60) in der Auskehlung (52),
- das Ausbilden eines Drain (84), der sich in Kontakt mit einem Ende des Säulchens befindet, das der Source-Schicht gegenüberliegt, und zwar über mindestens eine dazwischenliegende Tunnel-Isolierschicht (82).

2. Verfahren nach Anspruch 1, das weiter die Ausbildung von Verbindungsanschlüssen (92a, 92b, 94, 96) auf der Source-Schicht, auf dem Gate und auf dem Drain umfasst.

3. Verfahren nach Anspruch 1, bei dem die Ausbildung des isolierten Gate das Ablagern eines Gate-Isoliermaterials (62) und eines Gate-Materials (66) in der Auskehlung (52), und dann das Glätten dieser Schichten mit Stopp auf dem Säulchen umfasst.

4. Verfahren nach Anspruch 3, bei dem das erste Ätzen gemäß einer Schablonenschicht (24) durchgeführt wird und mindestens ein Abschnitt der Schablonenschicht (24) auf dem Säulchen während des zweiten Ätzens erhalten bleibt, und bei dem das Glätten mit Stopp auf dem Abschnitt der Schabinnenschicht stattfindet.

5. Verfahren zur Herstellung eines Coulomb-Blockade-Transistors, der auf einem Substrat aufweist:
- eine Übereinanderschichtung von Kanalschichten (22, 22i, 22c), wobei mindestens ein Quantenpunkt gebildet wird,
- einen Source (12) und einen Drain (80), die mit dem Quantenpunkt über dazwischenliegende Tunnelübergänge verbunden sind, von denen mindestens einer verschieden von den übereinandergeschichteten Schichten ist, und die mit den Kanalschichten übereinandergeschichtet sind.
- mindestens ein Gate (60) gegenüberliegend mindestens einer Flanke der Übereinanderschichtung,
- wobei die Übereinanderschichtung von Kanalschichten mindestens eine leitende Insel (22c) im Nanometergrößenbereich aufweist, die zwischen den elektrisch isolierenden Schichten (22i) angeordnet ist,
wobei das Verfahren die folgenden aufeinanderfolgenden Schritte umfasst:
- das Ablagern, auf einem isolierenden Substrat, einer Source-Schicht (12), einer Tunnef-Isolierschicht (20) und einer abwechselnden Übereinanderschichtung mindestens einer leitenden Schicht (22c) und mindestens einer isolierenden Schicht (22i),
- ein erstes Ätzen der Übereinanderschichtung gemäß einer Schablonenschicht (24), um einen Streifen (31) zu bilden,
- Umhüllen des Streifens mit einem elektrisch isolierenden Umhüllungsmaterial (40),
- ein zweites Ätzen des Streifens (31) der Übereinanderschichtung, um eine Säule (51) zu bilden, wobei beim zweiten Ätzen das Umhüllungsmaterial (40) erhalten bleibt, um eine Auskehlung (52) beiderseits der Säule (51) zu definieren, und wobei beim zweiten Ätzen ein Teil der Schablonenschicht (24) auf der Säule (51) erhalten bleibt,
- das Ausbilden mindestens eines isolierten Gate (60) in der Auskehlung (52),
- das Wegnehmen der Schablonenschicht (24), um einen Teil des isolierten Gate freizulegen, und das Ausbilden, gegen das isolierte Gate, mindestens eines Abstandhalters (63), der sich teilweise auf der Säule (51) erstreckt,
- das Ätzen der Säule (51), wobei der Abstandhalter (63) als Ätzmaske verwendet wird, so dass zumindest ein Teil der Säule (51), der unter dem Abstandhalter angeordnet ist, erhalten bleibt,
- das Wegschneiden der Säulchen (50) in dem erhaltenen Teil der Säule,
- das Isolieren der Säulchen, und
- das Ausbilden mindestens eines Drain (84) in Kontakt mit mindestens einem Ende eines Säulchens, das der Source-Schicht gegenüberliegt, über mindestens eine dazwischenliegende Tunnel-rsolierschicht (82).

6. Verfahren nach Anspruch 5, bei dem das Wegschneiden der Säulchen (50) umfasst:
- das Ausbilden, oberhalb des erhalten gebliebenen Teils der Säule, einer Opferdecke (100) aus Maskenmaterial, wobei mindestens eine Flanke oberhalb einer Kante mindestens einer auszubildenden Säule angeordnet ist,
- das Ausbilden mindestens eines Abstandhalters (104) auf der Flanke der Opferdecke (100),
- das Ätzen des erhalten gebliebenen Teils der Säule (51), wobei dabei der Abstandhalter der Opferdecke als Ätzmaske verwendet wird, damit mindestens ein Säulchen (50) unter diesem Abstandhalter erhalten bleibt.

7. Verfahren nach Anspruch 6, bei dem dem Ätzen des erhalten gebliebenen Teils der Säule (51) das Beseitigen der Opferdecke (100) vorausgeht.

8. Verfahren nach Anspruch 6, bei dem das Ätzen des erhalten gebliebenen Teils der Säule beinhaltet:
- ein erstes Ätzen unter Verwendung der Opferdecke (100) und des Abstandhalters (104) der Decke als Ätzmaske,
- das Verfestigen des verbleibenden Teils der Säule mittels eines elektrisch isolierenden Materials (108a),
- das Beseitigen der Opferdecke (100), wobei dabei der Abstandhalter (104) der Opferdecke erhalten bleibt, und
- ein zweites Ätzen unter Verwendung des Abstandhalters (104) der Opferdecke als Maske, um mindestens ein Säulchen (50) zu definieren.
